(19) Europäisches Patentamt
European Patent Office
Office européen des brevets

(11) **EP 1 796 108 A1**

(12) **EUROPEAN PATENT APPLICATION**
published in accordance with Art. 158(3) EPC

(43) Date of publication:
**13.06.2007 Bulletin 2007/24**

(51) Int Cl.:
*H01B 5/14* (2006.01)  *H01B 13/00* (2006.01)
*C23C 16/40* (2006.01)

(21) Application number: **05783376.6**

(22) Date of filing: **14.09.2005**

(86) International application number:
**PCT/JP2005/016897**

(87) International publication number:
**WO 2006/033268 (30.03.2006 Gazette 2006/13)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **24.09.2004 JP 2004276934**

(71) Applicant: **KONICA MINOLTA HOLDINGS, INC. Tokyo 100-0005 (JP)**

(72) Inventors:
• **KIYOMURA, T.,**
**/o Konica Minolta Tech. Center, Inc. Hino-shi,**
**Tokyo 191-8511 (JP)**
• **MAMIYA, C.,**
**c/o Konica Minolta Tech. Center, Inc. Hino-shi,**
**Tokyo 191-8511 (JP)**

• **KUDO, I.,**
**c/o Konica Minolta Tech. Center, Inc. Hino-shi,**
**Tokyo 191-8511 (JP)**
• **TSUJI, T.,**
**c/o Konica Minolta Tech. Center, Inc. Hino-shi,**
**Tokyo 191-8511 (JP)**
• **SAITO, A.,**
**c/o Konica Minolta Tech. Center, Inc. Hino-shi,**
**Tokyo 191-8511 (JP)**

(74) Representative: **Gille Hrabal Struck Neidlein Prop Roos**
**Patentanwälte**
**Brucknerstrasse 20**
**40593 Düsseldorf (DE)**

(54) **TRANSPARENT CONDUCTIVE FILM**

(57) An objective of the present invention is to provide a transparent conductive film exhibiting excellent adhesion to a substrate and excellent crack resistance, together with high transparency and conductivity. Also disclosed is a transparent conductive film comprising a substrate having thereon: a low density metal oxide layer made of metal oxide, and a high density metal oxide layer made of metal oxide that are alternately laminated layer by layer, wherein the transparent conductive film satisfies a condition specified by the following inequality (1); $1.01 \leq M2/M1 \leq 1.400$ ...(1), provided that a density of the low density metal oxide layer and a density of the high density metal oxide layer are represented by M1 and M2, respectively.

EP 1 796 108 A1

**Description**

**TECHNICAL FIELD**

The present invention relates to a transparent conductive film in which not only high transparency and conductivity are maintained, but also crack resistance together with adhesion to a substrate is improved.

**BACKGROUND**

A product with a transparent conductive layer having high visible light transmittance together with low electrical resistance (low specific resistance), a transparent conductive film, for example, has widely been utilized for quite some time in the various fields of flat panel display panels such as a liquid crystal image display apparatus, an organic electroluminescence image display apparatus (hereinafter, referred to also as organic EL), and of field emission type display (FED); a solar cell, electronic paper, a touch-sensitive panel, a electromagnetic wave shielding material and an infrared red reflection film. Examples of the transparent conductive film include a metal film made of Pt, Au, Ag or Cu; oxide such as $SnO_2$ $In_2O_3$, CdO, ZnO, Sb-doped $SnO_2$, F-doped $SnO_2$ Al-doped ZnO or Sn-doped $In_2O_3$, and nonoxide such as a dopant-induced composite oxide, chalcogenide, $LaB_6$, TiN or TiC. Of these, a tin-doped indium oxide film (hereinafter, referred to also as ITO) is most widely utilized in view of excellent electrical properties and easy processing via an etching treatment, and is formed by a method such as a vacuum evaporation method, a sputtering method, an ion plating method, a vacuum plasma CVD method, a spray pyrolysis method, a thermal CVD method or a sol-gel method.

High-quality transparent conductive films are recently demanded since large screen and high definition models of flat panel displays comprising an organic EL element have actively studied and developed. A high electric field-responsive element or apparatus is specifically demanded in a liquid crystal display element. Therefore, a transparent conductive film having a high electron mobility is demanded. A low-resistive transparent conductive film is also demanded, since a current-driving technique is employed in the organic EL element.

Usually, in the vacuum evaporation method and a sputtering method, a good balance between low-resistivity and high transparency is achieved by increasing crystallinity via adjustment of partial pressure of oxygen, control of oxygen deficiency in a film, or adjustment of deposited particle energy and substrate temperature to improve doping efficiency.

However, in the case of a single film prepared by the above-described method, cracks caused by stress generated in the film tend to be generated, though adhesion to a substrate is maintained. On the other hand, in the case of an amorphous film with less film-stress unlike a crystalline film, it is difficult to achieve a good balance between low-resistivity and transparency, though adhesion and crack resistance are excellent.

With respect to a problem concerning a single film as described above, proposed have been various methods in which low-resistivity is realized by laminating conductive metal oxide having a different metal composition or different crystallinity (refer to Patent Documents 1 - 3, for example). Further, conductivity is usually adjusted by controlling partial pressure of oxygen in the case of the vacuum evaporation method and the sputtering method, since it is known that oxygen deficiency in a film affects conductivity and transparency.

However, It was still difficult to produce a supple transparent conductive film having a small curvature radius by these proposed methods, because of deteriorated adhesion to a substrate and occurrence of cracks.

Further proposed is a transparent gas barrier layer-coated film obtained via alternate lamination of each of a film made of metal oxide and a film made of metal sulfide or metal phosphide (refer to Patent Document 4, for example). Also disclosed is a gas barrier film obtained via lamination of oxygen permeability inhibition layers or water vapor permeability inhibition layers by a vacuum evaporation method or a reduced pressure CVD method (refer to Patent Document 5, for example). In this case, a vacuum chamber is used, since the method proposed above is a method to produce multilayers by varying the carbon content in an inorganic oxide, and the vacuum evaporation method or the sputtering method usable for film formation is a method in which an intended substance is deposited in a vapor phase to grow a film. Therefore, productivity is low because of low efficiency in the use of raw material besides a large-sized apparatus at a high price. It is also difficult to form a large-sized film. Further, it is difficult to form a low-resistive transparent conductive film on a plastic film since temperature is desired to be increased to 200 - 300 °C during film formation to acquire low resistive products.

(Patent Document 1) Japanese Patent O.P.I. Publication No. 6-60723

(Patent Document 2) Japanese Patent O.P.I. Publication No. 8-174746

(Patent Document 3) Japanese Patent No. 3338093

(Patent Document 4) Japanese Patent O.P.I. Publication No. 2004-42412

(Patent Document 5) Japanese Patent O.P.I. Publication No. 2003-342735

## DISCLOSURE OF THE INVENTION

The present invention was made on the basis of the above-described situation, and an object of the present invention is to provide an transparent conductive film exhibiting excellent adhesion to a substrate and excellent crack resistance, together with high transparency and conductivity.

The foregoing object can be accomplished by the following structures.

(Structure 1) A transparent conductive film comprising a substrate having thereon: a low density metal oxide layer made of metal oxide; and a high density metal oxide layer made of metal oxide that are alternately laminated layer by layer, wherein the transparent conductive film satisfies a condition specified by the following inequality (1); $1.01 \leq M2/M1 \leq 1.400$ ...(1), provided that a density of the low density metal oxide layer and a density of the high density metal oxide layer are represented by M1 and M2, respectively.

(Structure 2) The transparent conductive film of Structure 1, wherein the low density metal oxide layers and the high density metal oxide layers are provided on a transparent substrate.

(Structure 3) The transparent conductive film of Structure 1, wherein the low density metal oxide layers and the high density metal oxide layers are provided on a flexible substrate.

(Structure 4) The transparent conductive film of any one of Structures 1 - 3, wherein the metal oxide comprises one element selected from the group consisting of In, Zn, Sn, Ti, Ga and Al.

(Structure 5) The transparent conductive film of any one of Structures 1 - 4, wherein the metal oxide comprises one metal oxide selected from the group consisting of $In_2O_3$, $ZnO$, $SnO_2$ and $TiO_2$.

(Structure 6) The transparent conductive film of any one of Structures 1 - 5, wherein each of the low density metal oxide layers and the high density metal oxide layers has a thickness of 0.1 20 nm.

(Structure 7) The transparent conductive film of any one of Structures 1 - 6, wherein at least one of the low density metal oxide layers and the high density metal oxide layers preferably has a gradient in density distribution in the layer.

(Structure 8) The transparent conductive film of any one of Structures 1 - 7, wherein the total number of the low density metal oxide layers and the high density metal oxide layers is at least 5 layers.

(Structure 9) The transparent conductive film of any one of Structures 1 - 8, prepared via process 1 comprising the steps of supplying gas 1 containing a metal oxide-forming gas in a first discharge space in which a high frequency electric field is generated for excitation; and forming the low density metal oxide layer made of the metal oxide on a substrate by exposing the substrate to the excited gas 1, and subsequently via process 2 further comprising the steps of supplying gas 2 containing an oxidizing gas in a discharge space in which a high frequency electric field is generated for excitation; and forming the high density metal oxide layer made of the metal oxide on the low density metal oxide layer by exposing the low density metal oxide layer to the excited gas 2.

(Structure 10) The transparent conductive film of Structure 9, wherein the gas 1 comprises a reducing gas.

## BRIEF DESCRIPTION OF THE DRAWINGS

[Fig. 1] A schematic view showing an example of the structure of the plate electrode type atmospheric pressure plasma discharge treatment apparatus of the preset invention.

[Fig. 2] A schematic view showing a film forming apparatus equipped with shielding blades preferably employed in the present invention.

[Fig. 3] A schematic view showing an example of a roller rotating electrode type atmospheric pressure plasma discharge treatment apparatus usable in the present invention.

[Fig. 4] A schematic diagram showing an atmospheric pressure plasma discharge treatment apparatus in which two roller rotating electrode type atmospheric pressure plasma discharge treatment apparatuses are connected in series.

[Fig. 5] A perspective view showing an example of a structure of a conductive metallic base material of the roller rotating electrode and covered thereon, a dielectic.

[Fig. 6] A perspective view showing an example of the structure of a conductive metallic base material of a square-shaped electrode and covered thereon, a dielectric.

## DESCRIPTION OF THE PREFERRED EMBODIMENTS

Next, the preferred embodiments of the present invention will be described in detail.

After considerable effort during intensive studies, the inventors have found out that excellent adhesion to a substrate and excellent crack resistance, together with high transparency and conductivity can be realized by utilizing a transparent conductive film comprising a substrate having thereon a low density metal oxide layer and a high density metal oxide layer made of metal oxide substantially having the same constituent components that are alternately laminated layer by layer, wherein the transparent conductive film possesses a density ratio (M2/M1) of at least 1.01 and at most 1.400, provided that a density of the low density metal oxide layer and a density of the high density metal oxide layer are represented by M1 and M2, respectively. In addition, the following embodiments can be utilized in the present invention as a method of laminating each of the above-described layers alternately.

(1) First, a low density metal oxide M1 layer is formed. After this, a high density processing treatment is conducted on the M1 layer by plasma discharge employing a discharge gas and an oxidizing gas to reform the M1 layer surface, and the reformed layer portion formed in the M1 layer surface portion becomes a high density metal oxide M2 layer. A transparent conductive film of the present invention can be obtained by repeating this step. Examples of the high density processing method include a method of heating a surface layer via infrared irradiation, a method of exposure to an oxidizing gas such as ozone and the like, a method of exposure to an oxidizing gas excited with plasma and so forth, but the high density processing method is not specifically limited thereto.

(2) Density (oxygen deficiency) of a metal compound layer to be formed under the conditions applied during production such as temperature, a reactive gas amount, and discharge density is measured in advance. After initially forming a low density metal oxide M1 layer, the foregoing conditions are changed, and subsequently a M2 layer is formed. A transparent conductive film of the present invention can be obtained by repeating this step.

A transparent conductive film exhibiting excellent flexibility and fragility resistance can be obtained even though a film is formed on a flexible substrate, since adhesion to a substrate and crack resistance can be improved with no deterioration of high conductivity and transparency via alternate lamination of metal oxide layers having different densities of conductive metal oxides (caused by oxygen deficiency). It is assumed that stress generated in the entire laminated film can be effectively released in the interlayer structure with different densities by alternately laminating layers having different densities specified by the present invention.

Next, the present invention will be described in detail.

First, a metal oxide constituting a metal oxide layer of the present invention will be described.

The transparent conductive film is commonly well-known as an industrial material, hardly absorbs visible light having a wavelength of 400 - 700 nm, is transparent, and also is a good conductor. It exhibits a transmission property of free charged objects carrying electricity is high in the visible light region, together with transparency, and is utilized as a transparent electrode or an antistatic film since electrical conductivity is high.

Incidentally, it is called "layer" in the present invention, but it may be able to be formed on an object to the extent functionable depending on the use application, and is not necessarily a continuous layer covering an object partly or entirely. Examples of transparent conductive films include a metal thin film made of Pt, Au, Ag or Cu; oxides and dopant-induced composite oxides such as $SnO_2$ $In_2O_3$, CdO, Sb-doped $SnO_2$ F-doped $SnO_2$ Al-doped ZnO (abbreviated name: AZO), Ga-doped ZnO (abbreviated name: GZO) and Sn-doped $In_2O_3$ (abbreviated name: ITO); and a nonoxide film made of $In_2O_3$-ZnO based amorphous oxide (abbreviated name: IZO), chalcogenide, $LaB_6$, TiN or TiC. Of these, specifically Sn-doped $In_2O_3$ film (ITO film) is widely utilized in view of the excellent electrical property together with the easy etching treatment. The ITO and AZO films have an amorphous structure or a crystalline structure. On the other hand, the IZO film has an amorphous structure.

In the present invention, an organic metal compound having an oxygen atom in a molecule is preferable as a reactive gas employed for formation of a metal oxide layer being a principal component of the transparent conductive film in the after-mentioned atmospheric pressure plasma CVD method by which films are formed at or near atmospheric pressure. Examples thereof include indium hexafluoropentanedionate, indium methyl(trimethyl)acetylacetate, indium acetylacetonate, indium isopropoxide, indium tri fluoropentanedionate, tris(2,2,6,6-tetramethyl3,5-heptanedionate) indium, di-n-butylbis(2,4-pentanedionate) tin, di-n-butyldiacetoxy tin, di-t-butyldiacetoxy tin, tetraisopropoxy tin, tetrabutoxy tin, zinc acetylacetonate and so forth. Of these, preferable are indium acetylacetonate, tris(2,2,6,6-tetramethyl3,5-heptanedionate) indium, zinc acetylacetonate and di-n-butyldiacetoxy tin.

Examples of the reactive gas employed for doping include aluminum isopropoxide, nickel acetylacetate, manganese acetylacetate, boron isopropoxide, n-butoxy antimony, tri-n-butyl antimony, di-n-butylbis(2,4-pentanedionate) tin, di-n-butyldiacetoxy tin, di-t-butyldiacetoxy tin, tetraisopropoxy tin, tetrabutoxy tin, tetrabutyl tin, zinc acetylacetate, hexafluoropropylene, octafluorocyclobutane and tetrafluoromethane.

Examples of the reactive gas employed for adjusting resistance of a transparent conductive film include titanium triisopropoxide, tetramethoxysilane, tetra ethoxysilane and hexamethyldisiloxane.

The transparent conductive film of the present invention preferably contains at least one element selected from In, Zn, Sn, Ti, Ga and Al, and the metal oxide preferably contains at least one selected from $In_2O_3$, ZnO, $SnO_2$ and $TiO_2$. In this case, a carbon atom or a nitrogen atom may be contained as a subcomponent, but the carbon atom or nitrogen atom content is preferably at most 20 atomic % in view of preparation of a transparent conductive film to satisfy the objective of the present invention.

An amount ratio of a small amount of reactive gas used for doping to a reactive gas used for a transparent conductive film as a principal component is varied depending on kinds of transparent conductive films to be deposited. The reactive gas amount is adjusted in such a way that an atomic number ratio [Sn/(In + Sn)] of an ITO film obtained via doping of Sn into indium oxide, for example, is within the range of 0.1 - 30 atomic %, but preferably within the range of 0.1 - 20 atomic %. The atomic number ratio of In and Sn can be determined by XPS measurements.

As for a transparent conductive film obtained via doping of fluorine into tin oxide (FTO), a reactive gas amount ratio is adjusted in such a way that an atomic number ratio [F/(Sn + F)] of the resulting FTO film is within the range of 0.01 - 30 atomic %. The atomic number ratio of Sn and F can be determined by XPS measurements.

As for a transparent conductive film obtained via doping of aluminum into ZnO (AZO), a reactive gas amount ratio is adjusted in such a way that an atomic number ratio [Al/(Zn + Al)] of the resulting AZO film is within the range of 0.1 - 30 atomic %. The atomic number ratio of Al and F can be determined by XPS measurements.

As for $In_2O_3$-ZnO based amorphous transparent conductive film (IZO), a reactive gas amount ratio is adjusted in such a way that an atomic number ratio [In/(Zn + In)] of the resulting IZO film is within the range of 10 - 90 atomic %. The atomic number ratio of In and Zn can be determined by XPS measurements.

The value can be measured employing an XPS (X-ray photoelectron spectroscopy) surface analyzing apparatus. In the present invention, employed was an X-ray photoelectron spectroscopic surface analyzing apparatus ESCALAB-200R manufactured by VG Scientifix Co., Ltd. The measurement was carried out specifically with an X-ray of 600W (acceleration voltage: 15 kV, emission current: 40 mA) employing an X-ray anode of Mg. The energy resolution was set at 1.5 eV to 1.7 eV by a half width value of the peak of cleared Ag3d5/2.

First, the kind of detectable element was determined by searching the range of bonding energy of 0 - 1,100 eV at a signal input interval of 1.0 eV.

Next, slow scanning at a signal input interval of 0.2 eV was performed for detecting photoelectron peaks exhibiting the maximum intensity for entire elements except for the ion for etching to measure the spectra of each element.

The resulting spectra were transferred to Common Data Processing Process (Preferably after Ver. 2.3) manufactured by VAMAS-SCA-Japan and processed by the same software in order to avoid a calculated content result difference caused by a measuring apparatus or computer. Thus the content of each target element such as carbon, oxygen, silicon or titanium was obtained in atomic concentration (at%) .

Count scale calibration was applied for each element before a quantitative determination treatment and the results were subjected to a 5-point smoothing treatment. The peak area intensity (eps*eV) after removing the background was used for quantitative determination treatment. The Shirley method was used for a back ground treatment, referring to D. A. Shirley, Phys. Rev., B5, 4709 (1972).

A transparent conductive film of the present invention comprising a substrate having thereon a low density metal oxide layer and a high density metal oxide layer made of metal oxide substantially having the same constituent components that are alternately laminated layer by layer, wherein the transparent conductive film possesses a density ratio (M2/M1) of at least 1.01 and at most 1.400, preferably has a density ratio (M2/M1) of at least 1.030 and at most 1.300, and more preferably has a density ratio (M2/M1) of at least 1.05 and at most 1.200, provided that a density of the low density metal oxide layer and a density of the high density metal oxide layer are represented by M1 and M2, respectively.

The density of each metal oxide layer specified by the present invention can be determined by a commonly known analysis means, but in the present invention, it is determined by X-ray reflectometry.

The X-ray reflectometry measurement can be made referring to page 151 of "Hand Book of X Ray Diffraction" edited by Rigaku Denki Co., Ltd. (published by Kokusai Bunken Insatsu Corp., 2000) and No. 22 of "Kagaku Kougyo"(January 1999).

A specific example of a measuring method usable in the present invention will be described below.

Measurement is conducted employing a measuring apparatus MAC Science MXP21. Cu is used as a target of an X-ray source to operate at 42 kV and 500 mA. A multilayer parabolic mirror is employed for an incident monochromator. An entrance slit of 0.05 mm x 5 mm and an acceptance of 0.03 mm x 20 mm are used. Measurement from 0° to 5° by a step width of 0.005° is carried out with 10 seconds for one step employing a FT method. Curve fitting is conducted for the resulting reflectivity curve employing MAC Science Reflectivity analysis Program Ver.1 to determine each of parameters so as to minimize the residual sum of squares between the actual measurement value and the fitting curve. Densities M1 and M2, and thicknesses D1 and D2 corresponding to the foregoing M1 and M2 can be determined from each of the resulting parameters. In addition, each density of the resulting low density oxide layer and the high density oxide layer can also be determined via X-ray reflectrometry measurement as an average density.

As to the transparent conductive film of the present invention, each of low and high density metal oxide layers preferably has a thickness of 1 - 20 nm.

It is a feature that the transparent conductive film of the present invention has a structure in which the low density metal oxide layer and the high density metal oxide layer are alternately laminated, and it is preferable that the low density metal oxide layer and the high density metal oxide layer are alternately laminated on a substrate. It is also preferable that at least 5 layers of the low density metal oxide layer and the high density metal oxide layer are alternately laminated. For example, in the case of a 5 layer structure, a low density metal oxide layer, a high density metal oxide layer, a low density metal oxide layer, a high density metal oxide layer and a low density metal oxide layer are provided from the substrate side. The upper limit of the total number of layers is roughly at most 50 layers, depending on characteristics of the resulting transparent conductive film, but preferably at most 30 layers.

As to the transparent conductive film, one of the low density metal oxide layers or one of the high density metal oxide layers preferably has a gradient in density distribution in the thickness direction.

As a method in which a gradient in density distribution is produced in the thickness direction as to the transparent conductive film of the present invention, there is a method in which a gap between electrodes is varied by tilting fixed electrodes with respect to a roller rotating electrode during film formation via the after-mentioned atmospheric pressure plasma method preferably usable in the present invention, or a supply amount and kinds of supplied raw material for film formation, and an output power condition during plasma discharge are appropriately selected to realize the foregoing gradient in density distribution in the thickness direction.

The transparent conductive film of the present invention is preferably formed on a transparent substrate, and it is not specifically limited, provided that the film is made of a material which can constitute a metal oxide layer.

Usable examples thereof include a homopolymer or a copolymer such as ethylene, polypropylene or butane; an amorphous polyolefin (APO) resin such as a polyolefin (PO) resin or cyclic polyolefin; a polyester based resin such as polyethylene terephthalate (PET) or polyethylene 2,6-naphthalate (PEN); a polyamide (PA) based resinsuch as nylon 6, nylon 12 or copolymerization nylon; a polyvinyl alcohol (PVA) based resin such as a polyvinyl alcohol (PVA) resin or ethylene-vinyl alcohol copolymer (EVOH); and a fluorine based resin such as a polyimide (PI) resin, a polyetherimide (PEI) resin, a polysulfone (PS) resin, a polyethersulfone (PES) resin, a polyether ether ketone (PEEK) resin, a polycarbonate (PC) resin, a polyvinyl butyrate (PVB) resin, a polyacrylate (PAR) resin, ethylene-tetrafluoroethylene (PTFE), chlorotrifluoroethylene (PFA), tetrafluoroethylene-per-fluoroalkylvinylether copolymer (FEP), vinylidene fluoride (PVDF), vinyl fluoride (PVF) or perfluoroethylene-perfluoropropylene-per-fluorovinylether-copolymer (EPA).

In addition to the above-described resins, further usable are light-curable resins and the admixture thereof such as a resin composition composed of an acrylate compound containing a radical reactivity unsaturated compound; a resin composition composed of a mercapto compound containing the acrylate compound and a thiol group; and a resin composition in which oligomer such as epoxyacrylate, urethaneacrylate, polyesteracrylate or polyetheracrylate is dissolved in a polyfunctional acrylate monomer. Also usable is a substrate film obtained via lamination with a laminating or coating means employing at least one of these resins.

These may be used singly or as an admixture of two or more thereof. ZEONEX or ZEONOR (produced by Nippon Zeon Co., Ltd., an amorphous cyclopolyolefin film ARTON (produced by JSR Corporation), a polycarbonate film Pureace (produced by Teijin Limited), and a cellulose triacetate film KONICATAC KC4UX, KC8UX (produced by Konica Minilta Opto, Inc.) available on the market are preferably used.

In the case of a transparent conductive film of the present invention, it is possible to produce a transparent substrate utilized for an organic EL element and so forth, since a substrate is transparent, and a metal oxide layer formed on the substrate is also transparent.

A substrate of the present invention made of the above-described resin may be unstretched or stretched.

The substrate of the present invention is possible to be prepared by a commonly known conventional method. For example, an unstretched substrate which is substantially amorphous with no orientation can be prepared by a quenching process after extruding a dissolved resin material via an annular die or a T die employing an extruder. An unstreached substrate is also oriented in the substrate running direction (vertical axis) or in the direction at right angle to the substrate running direction (horizontal axis) by a commonly known method such as a uniaxially stretching method, a tenter type individual biaxially stretching method, a tenter type simultaneous biaxially stretching method or a tubular type simultaneous biaxially stretching method to produce a stretched substrate. In this case, a stretching magnification is preferably 2 - 10 times in each of the vertical axis direction and the horizontal axis direction, though the magnification can be selected appropriately to fit a resin as a substrate material.

A substrate of the present invention may also be subjected to a surface treatment such as a corona treatment, a flame treatment, a plasma treatment, a glow discharge treatment, a surface roughening treatment or a chemical treatment before forming an evaporated layer.

Further, an anchor coat agent layer may be formed in order to improve adhesion between an evaporated layer and the substrate surface of the present invention. As an anchor coat agent used for an anchor coat agent layer, usable is/are one or two kinds of a polyester resin, an isocyanate rsin, an urethane resin, an acrylic resin, an ethylene vinylalcohol resin, a vinyl-modified resin, an epoxy resin, a modified styrene resin, a modified silicon resin and alkyltitanate in combination. A commonly known additive may be added into the above-described anchor coat agent. The above-described anchor coat agent is coated onto a substrate by commonly known methods such as a roll coat method, a gravure coat method, a knife coat method, a dip coat method and a spray coat method to conduct anchor coating by dry-removing a solvent, a diluent and so forth. A coating amount of the above-described anchor coat agent is preferably about 0.1 - 5

$g/m^2$ (dry condition).

The long-length type in the roll form is usable for a substrate. The substrate in the form of a film usable in the present invention preferably has a thickness of 10 - 200 $\mu$m, and more preferably has a thickness of 50 - 100 $\mu$m.

Next, a method of forming a transparent conductive film of the present invention on a substrate will be described.

Examples of a method of forming a transparent conductive film include a sputtering method, a coating method, an ion assist method, a plasma CVD method, or the after-mentioned plasma CVD method conducted at or near atmospheric pressure, but the plasma CVD method and the plasma CVD method conducted at or near atmospheric pressure are preferable as the method of forming a transparent conductive film of the present invention, and the plasma CVD method conducted at or near atmospheric pressure is more preferable.

Next, the atmospheric pressure plasma CVD method which is preferably usable for formation of low and high density metal oxide layers as a method of manufacturing a transparent conductive layer of the present invention will be described in detail.

The plasma CVD method is also called as plasma assisting chemical vapor deposition method or PECVD method, by which a layer of various inorganic substances exhibiting high coat and adhesion ability can be obtained for any solid-shaped body with no large increase of a substrate temperature.

The conventional CVD method (chemical vapor deposition method) is a method in which the evaporated or sublimated organic metal compound adheres to the substrate surface at high temperature, and thermally decomposed to form a thin layer composed of a thermally stable inorganic substance. Such the conventional CVD method is not usable for a layer formed on the plastic substrate since a substrate temperature of at least 500 °C is desired.

In the case of a plasma CVD method, a space in which gas being at a plasma state (plasma space) is generated by applying an electric field in the space near the substrate. The evaporated or sublimated organic metal compound is introduced into the plasma space, decomposed and then blown onto the substrate to form the thin layer composed of an inorganic substance. In the plasma space, the gas is ionized into ions and electrons in a high ratio of several percent, and the electron temperature becomes very high though the gas is kept at low temperature. Therefore, the organic metal compound as a raw material for an inorganic layer can be decomposed by contact of the high temperature electrons and the low temperature ion radicals. Accordingly, the temperature of the substrate can be lowered in the case of preparation of an inorganic substance, whereby the layer can be sufficiently formed on a plastic substrate by this method.

However, there is a problem such as low productivity since the plasma CVD method requires a large-sized apparatus with complicated operation to produce a large-size film, because the layer is usually formed in a space at reduced pressure of roughly 0.101 - 10.1 kPa, and an electric field needs to be applied to the gas in order to ionize the gas at a plasma state.

In addition, a near atmospheric pressure plasma CVD method exhibits higher productivity and higher film formation rate than that of an under vacuum plasma CVD method, since the reduced pressure process can be avoided, and the plasma density is also high. Further, the gas mean free path under the high pressure condition of atmospheric pressure is so short in comparison to that of the condition of the conventional CVD method, that a very smooth film exhibiting excellent optical properties can be obtained. Therefore, the atmospheric pressure plasma CVD method is more preferably usable in the present invention than the under vacuum plasma CVD method.

A transparent conductive film of the present invention is preferably prepared via process 1 comprising the steps of supplying gas 1 containing a metal oxide-forming gas in a first discharge space in which a high frequency electric field is generated for excitation; and forming the low density metal oxide layer made of the metal oxide on a substrate by exposing the substrate to the excited gas 1, and subsequently via process 2 further comprising the steps of supplying gas 2 containing an oxidizing gas in a discharge space in which a high frequency electric field is generated for excitation; and forming the high density metal oxide layer made of the metal oxide on the low density metal oxide layer by exposing the low density metal oxide layer to the excited gas 2. Further, preferable is the transparent conductive film, wherein gas 1 comprises a reducing gas.

Incidentally, "excited gas" described in the present invention means that at least a part of molecules in a gas is moved to a high energy level from the present low energy level by receiving energy, and applicable is a gas containing excited gas molecules, radical gas molecules or ionized gas molecules.

That is, a discharge space between facing electrodes is arranged at or near atmospheric pressure, and a metal oxide-forming gas containing a discharge gas, a reducing gas and a metal oxide gas is introduced into the discharge space between facing electrodes to set the a metal oxide-forming gas at a plasma state by applying a high frequency voltage between the facing electrodes. Subsequently, a low density metal oxide layer is formed on a transparent substrate by exposing the transparent substrate to the metal oxide-forming gas at the plasma state. Next, a high density metal oxide layer is formed on the low density metal oxide layer by exposing the low density metal oxide layer formed on the transparent substrate to the gas in which a discharge gas and a oxidizing gas are excited at a plasma state. The transparent conductive film of the present invention in which the low density metal oxide layer and the high density metal oxide layer are alternately laminated is prepared by repeating the above-described steps.

As to the transparent conductive film, a high density metal oxide layer is formed by exposing a transparent conductive film to an oxidizing gas immediately after forming a low density metal oxide layer with an applied high frequency voltage employing a reducing gas. Not only a transparent conductive film having a specific resistance of $10^{-4}$ $\Omega\cdot$cm can be formed by repeating these steps of forming the low density metal oxide layer employing the reducing gas, and forming the high density metal oxide layer via exposure to an excited gas containing the oxidizing gas, but also the transparent conductive film exhibiting improved adhesion to a substrate, together with excellent crack resistance can be obtained since the transparent conductive film formed by such the method results in exhibiting very high film hardness.

Next, the gas to form a transparent conductive film of the present invention will be described. The gas employed in the present invention is the gas basically containing a discharge gas and a transparent conductive film-forming gas.

The discharge gas is a rare gas or nitrogen gas which plays a role in producing excitation or a plasma state by energizing a conductive layer film-forming gas in a discharge space. An element in Group 18 of a periodic table such as helium, neon, argon, krypton, xenon or radon can be provided as a rare gas, but helium and argon are preferably usable in order to achieve a dense and low-resistive film-forming effect described in the present invention. A discharge gas concentration of 90.0 - 99.9% by volume is preferably contained in the total gas of 100% by volume.

As to formation of a low density metal oxide layer of the present invention, the transparent conductive film-forming gas is a gas in which an excited state or a plasma state is generated by receiving energy from a discharge gas in a discharge space to form a transparent conductive film, or by which reaction is also controlled or accelerated. This transparent conductive film-forming gas preferably has a content of 0.01 - 10% by volume, based on the total gas, and more preferably has a content of 0.1 - 3% by volume.

As to formation of the low density metal oxide layer of the present invention, the resulting transparent conductive film can be made more evenly and densely by containing a reducing gas selected from hydrogen, hydrocarbon such as methane, and $H_2O$ gas in a transparent conductive film-forming gas, whereby properties such as conductivity, adhesion and crack resistance can be improved. The reducing gas preferably has a content of 0.0001 - 10% by volume, based on the total gas of 100% by volume, and more preferably has a content of 0.001 - 5% by volume.

A high density oxide layer of the present invention is formed by exposing the above-described low density oxide layer to a gas obtained by exciting a discharge gas or an oxidizing gas at a plasma state. Usable examples of the oxidizing gas include oxygen, ozone, hydrogen peroxide, carbon dioxide and so forth. Examples of the discharge gas in this case include nitrogen, helium and argon. The concentration of the oxidizing gas component is preferably 0.0001 - 30% by volume, based on the mixture of the oxidizing gas with the discharge gas, more preferably 0.001 - 15% by volume, and still more preferably 0.01 - 10% by volume. An optimal concentration value of each gas selected from oxidizing gases and gases such as nitrogen, helium and argon can be arranged by appropriately setting the conditions of a substrate temperature, the trial number of oxidation treatment and treating time. As the oxidizing gas, oxygen and carbon dioxide are preferable, but a mixture of oxygen with argon is more preferable.

An apparatus of forming a metal oxide layer at or near atmospheric pressure by a plasma CVD method will be described below.

In the present invention, the plasma discharge processing is carried out at or near atmospheric pressure. The atmospheric pressure or near atmospheric pressure means a pressure of 20 - 110 kPa, but a pressure of 93 - 104 kPa is preferable to produce effective results described in the present invention.

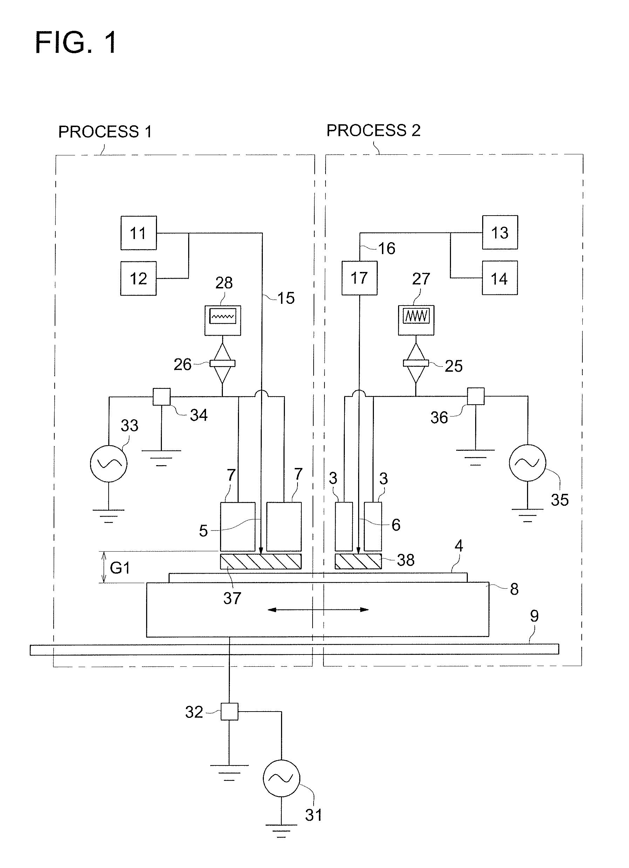

As to a method of producing a transparent conductive film of the present invention, an example of the plasma film forming apparatus utilized to form low and high density metal oxide layers will be described, referring to Figs. 1 - 6.

The present invention relates to a film forming method in which at or near atmospheric pressure, gas 1 containing a film forming gas is supplied to a discharge space, gas 1 is excited by applying a high frequency electric field in the discharge space, and a substrate is exposed to excited gas 1 to conduct at least process 1 and form a layer on the substrate. In this film forming method, after process 1, conducted is process 2 in which at or near atmospheric pressure, gas 2 containing an oxidizing gas is supplied to the discharge space, gas 2 is excited by applying a high frequency electric field in the discharge space, and a substrate with a film layer is exposed to excited gas 2, whereby high quality films can be prepared even at high speed of production.

As to process 1 in preparation of a transparent conductive film of the present invention, Gas 1 supplied to the space between the electrodes facing each other (discharge space) at least contains a discharge gas excited by an electric field and a film forming gas formed by producing a plasma state or an exited state caused by receiving the energy of the excited discharge gas.

In the present invention, it is preferable to conduct process 2 after process 1, in which: at or near atmospheric pressure, gas 2 containing an oxidizing gas is supplied to a discharge space, gas 2 is excited by applying a high frequency electric field in the discharge space, and a substrate with a film layer is exposed to excited gas 2.

Gas 2 preferably contains a discharge gas, and the discharge gas preferably contains at least 50 % of nitrogen in view of production cost.

It is preferable that process 1 and process 2 are alternately repeated. Applicable may be either a method in which a substrate is treated by moving back and forth between process 1 and process 2, or a method in which a substrate is continuously treated by passing through process 1 regions and process 2 regions alternately set up.

Next, the present invention will be further described in detail.

First, process 1 will be described.

The high frequency electric field of process 1 is preferably formed by superposing the first high frequency electric field and the second high frequency electric field. The discharge space is formed between the first electrode and the second electrode which are facing each other, and preferably, the first high frequency electric field is applied by the first electrode and the second high frequency electric field is applied by the second electrode.

Preferable are those:

the frequency of the first high frequency electric field $\omega 1$ is higher than a frequency of the second high frequency electric field $\omega 2$;
the intensity of the first high frequency electric field represented by V1, the intensity of the second high frequency electric field represented by V2, and intensity of discharge starting electric field represented by IV1 satisfy one of the formulas:

$$V1 \geq IV1 > V2 \text{ and } V1 > IV1 \geq V2; \text{ and}$$

the power density to give the second high frequency electric field is not less than 1 W/cm$^2$.

When each of the high frequency electric fields to be superposed takes the form of a sine wave, the superposed electric field of the first high frequency electric field having the frequency of $\omega 1$ and the second high frequency electric field having the frequency of $\omega 2$ which is higher than $\omega 1$ takes the form of a saw-tooth wave in which the sine wave of $\omega 2$ which is higher than $\omega 1$ is superposed on the sine wave of $\omega 1$.

In the present invention, intensity of discharge starting electric field represents lowest intensity of the electric field which can initiate discharge in an actual discharge space (for example, configuration of electrode) under an actual reaction condition (for example, employed gases, and such) used for the film forming method. The intensity of discharge starting electric field depends, to a certain degree, on the kind of supplied gas to the discharge space, the kind of the dielectric material used for the electrode, and the distance between the electrodes, however, in the same discharge space, it depends on the intensity of discharge starting electric field of the discharge gas.

By applying a high frequency electric field to a discharge space, discharge necessary to form a film is initiated and a high density plasma necessary to form a film is generated.

In the above description, superposition of continuous sine waves are described, however, the present invention is not limited only to that. Both electric fields may be of continuous waves, or only one of the electric fields may be a continuous wave and another may be a pulse wave. Further, a third electric field may be used.

Herein, the intensity of high frequency electric field (high frequency electric field intensity) and intensity of discharge starting electric field represent the values determined by the methods described below.

Measuring method of high frequency electric field intensity $V_1$ and $V_2$ (kV/mm):

High frequency voltage probe (P6015A) is placed at each electrode output signal of which is connected to oscilloscope TDS 3012B (produced by Tektronix Co., Ltd.), and electric field intensity is measured.

Measuring method of intensity of electric field at which discharge is initiated IV (kV/mm):

Discharge gas is supplied to a discharge space between the electrodes, and when electric field intensity applied to the electrodes is increased, electric field intensity at which discharge starts is defined as intensity of discharge starting electric field IV. The measuring device is the same as described above for the measurement of high frequency electric field.

When discharge conditions in the present invention are employed, even a gas with high intensity of discharge starting electric field such as a nitrogen gas can start discharge, and stable plasma with high density is maintained to form a film at high speed.

When discharge gas is a nitrogen gas, its intensity of discharge starting electric field IV (1/2 Vp-p) is approximately 3.7 kV/mm, and the nitrogen gas can be excited by application of a first high frequency electric field intensity of $V1 \geq 3.7$ kV/mm to be in plasma state.

The frequency of the first power supply is preferably not more than 200 kHz. The electric field waveform may be a pulse wave or a continuous wave. The lower limit of the frequency is preferably about 1 kHz.

The frequency of the second power supply is preferably not less than 800 kHz. As the frequency of the second power supply is increased, plasma density becomes higher, resulting a film with higher quality. The upper limit of the frequency is preferably about 200 MHz.

The application of high frequency electric field from two power supplies as described above is necessary in the present invention, in order to start discharge of a discharge gas having a high intensity of discharge starting electric field in the first high frequency electric field. Also, it is important to form a dense and high quality film by increasing plasma density with the high frequency and high power density of the second high frequency electric field.

Further, the power density of the second high frequency electric field can be increased while uniform discharge is maintained by increasing employing the power density of the first high frequency electric field, whereby more uniform plasma with higher density can be produced, resulting in improvement of film forming rate and film quality.

As described above, a film is formed on a substrate by: starting discharge between electrodes facing each other; exciting gas 1 containing a film forming gas to a plasma state, gas 1 being supplied to the space between the above electrodes facing each other; and exposing a substrate to excited gas 1. The substrate may be left at rest or transported between the electrodes facing each other.

Next, process 2 will be described.

In the present invention, it is desired that process 2 is carried out after foregoing process 1 in which gas 2 containing an oxidizing gas is excited by an atmospheric pressure plasma discharge treatment treatment; and the film above described is exposed to excited gas 2. Thus, a high quality film is formed even at high speed.

The high frequency electric field of process 2 is also formed by preferably superposing the third high frequency electric field and the fourth high frequency electric field. The discharge space is formed between the third electrode and the fourth electrode which are facing each other, and preferably, the third high frequency electric field is applied by the third electrode and the fourth high frequency electric field is applied by the fourth electrode. Thus, a dense and high quality film is formed.

In view of formation of a high quality film, preferable is that:

a frequency of the third high frequency electric field represented by $\omega3$ is higher than a frequency of the fourth high frequency electric field represented by $\omega4$;
intensity of the third high frequency electric field represented by V3, intensity of the fourth high frequency electric field represented by V4, and intensity of discharge starting electric field represented by IV2 satisfy one of the formulas:

$$V3 \geq IV2 > V4 \text{ and } V3 > IV2 \geq V4; \text{ and}$$

a power density of the fourth high frequency electric field is not less than $1W/cm^2$.

The third power supply and the fourth power supply which supply the third electric field and the fourth electric field, respectively, and the method of power supply are the same described for the first electric field and the second electric field in foregoing process 1.

<Interelectrode gap>

When one of the electrodes has a dielectric layer, the space distance between the first and second electrodes facing each other is a minimum distance between the dielectric layer surface and the conductive metal base material surface of the other electrode, and, when each of the facing electrodes described above have a dielectric layer, the space distance is a minimum distance between the both dielectric layer surfaces. The space distance is determined considering thickness of a dielectric layer provided on the conductive metal base material, magnitude of strength of electric field applied, or an object of employing plasma. The space distance is preferably 0.1 - 5 mm, and more preferably 0.5 - 2 mm, in view of conducting a uniform discharge.

<Vessel>

The apparatus for the atmospheric pressure plasma discharge treatment of the present invention is preferably enclosed in one vessel or enclosed in two vessels in which process 1 and process 2 each are independently enclosed, in order to avoid the influence of outside air. A vessel is preferably composed of pyrex (R) glass, however, a metal vessel may be used, provided that insulation against the electrode is provided. For example, the vessel may be a vessel made of aluminum or stainless steel laminated with a polyimide resin or a vessel made of metal which is thermally sprayed with ceramic to form an insulation layer on the surface.

<Power source>

Examples of the first power source (high frequency power source) and the third power source (high frequency power source) equipped in the atmospheric pressure plasma discharge treatment apparatus of the present invention include the following power sources available on the market:

| Maker | Frequency | Product name |
|---|---|---|
| Shinko Denki | 3 kHz | SPG3-4500 |
| Shinko Denki | 5 kHz | SPG5-4500 |
| Kasuga Denki | 15 kHz | AGI-023 |
| Shinko Denki | 50 kHz | SPG50-4500 |
| Heiden Kenkyusho | 100 kHz* | PHF-6k |
| Pearl Kogyo | 200 kHz | CF-2000-200k |
| Pearl Kogyo | 400 kHz | CF-2000-400k |

Any commercially available power source described above is usable.

Examples of the second power source (high frequency power source) and the fourth power source (high frequency power source) include the following power sources available on the market:

| Maker | Frequency | Trade name |
|---|---|---|
| Pearl Kogyo | 800 kHz | CF-2000-800k |
| Pearl Kogyo | 2 MHz | CF-2000-2M |
| Pearl Kogyo | 13.56 MHz | CF-2000-13M |
| Pearl Kogyo | 27 MHz | CF-2000-27M |
| Pearl Kogyo | 150 MHz | CF-2000-150M |

Any commercially available power source listed above is usable.

In the power sources above, "*" represents an impulse high frequency power supply (100 kHz in continuous mode) manufactured by Heiden Kenkyusho, and others are high frequency power supplies capable of applying electric field with only continuous sine wave.

<Electric power>

In the present invention, when power is supplied across the facing electrodes, power (power density) of not less than 1 $W/cm^2$ is supplied to the second electrode (the second high frequency electric field) and to the fourth electrode (the fourth high frequency electric field) to generate plasma, and give the resulting energy to gas 1 or gas 2. The upper limit of power supplied to the second electrode is preferably 50 $W/cm^2$, and more preferably 20 $W/cm^2$. The lower limit of power supplied is preferably 1.2 $W/cm^2$. The discharge surface area ($cm^2$) refers to the surface area of the electrode in which discharge is generated.

Further, power density can be improved while uniformity of the second high frequency electric field is maintained, by supplying power (power density) of not less than 1 $W/cm^2$ to the first electrode (first high frequency electric field) and the third electrode (third high frequency electric field), whereby more uniform plasma with higher density can be produced, resulting in improvement of film forming rate and film quality. Power supplied to the first electrode and the third electrode is preferably not less than 5 $W/cm^2$. The upper limit of power supplied to the first electrode and the third electrode is preferably 50 $W/cm^2$.

<Electric current>

Herein, the relationship between the currents of the first electric field I1 and the second electric field I2 is preferably I1 < I2. I1 is preferably 0.3 $mA/cm^2$ to 20 $mA/cm^2$, and more preferably 1.0 $mA/cm^2$ to 20 $mA/cm^2$ , and I2 is preferably 10 $mA/cm^2$ to 1000 $mA/cm^2$, and more preferably 20 $mA/cm^2$ to 500 $mA/cm^2$.

The relationship between the currents of the third electric field 13 and the fourth electric field 14 is preferably 13 < 14. 13 is preferably 0.3 $mA/cm^2$ to 20 $mA/cm^2$, and more preferably 1.0 $mA/cm^2$ to 20 $mA/cm^2$. I4 is preferably 10 $mA/cm^2$ to 1000 $mA/cm^2$, and more preferably 20 $mA/cm^2$ to 500 mA / cm2 .

<Waveform>

Herein, the waveform of the high frequency electric field is not specifically limited. There are a continuous oscillation mode which is called a continuous mode with a continuous sine wave and a discontinuous oscillation mode which is called a pulse mode carrying out ON/OFF discontinuously, and either may be used, however, a method supplying the continuous sine wave at least to the second electrode side (the second high frequency electric field) is preferred in obtaining a uniform film with high quality.

<Electrode>

It is desired that electrodes used in the atmospheric pressure plasma discharge film forming method structurally and functionally resist the use under severe conditions. Such electrodes are preferably those in which a dielectric is coated on a metal base material.

In the dielectric-coated electrode used in the present invention, the dielectric and metal base material used in the present invention are preferably those in which their properties meet. For example, one embodiment of the dielectric-coated electrodes is a combination of conductive metal base material and a dielectric in which the difference in linear thermal expansion coefficient between the conductive base material and the dielectric is not more than $10 \times 10^{-6}/°C$. The difference in linear thermal expansion coefficient between the conductive metal base material and the dielectric is preferably not more than $8 \times 10^{-6}/°C$, more preferably not more than $5 \times 10^{-6}/°C$, and most preferably not more than $2 \times 10^{-6}/°C$. Herein, the linear thermal expansion coefficient is a physical value specific to known materials.

Combinations of conductive base material and dielectric having a difference in linear thermal expansion coefficient between them falling within the range as described above will be listed below.

1. A combination of pure titanium or titanium alloy as conductive metal base material and a thermal spray ceramic layer as a dielectric layer
2: A combination of pure titanium or titanium alloy as conductive metal base material and a glass lining layer as a dielectric layer
3: A combination of stainless steel as conductive metal base material and a thermal spray ceramic layer as a dielectric layer
4: A combination of stainless steel as conductive metal base material and a glass lining layer as a dielectric layer
5: A combination of a composite of ceramic and iron as conductive metal base material and a thermal spray ceramic layer as a dielectric layer
6: A combination of a composite of ceramic and iron as conductive metal base material and a glass lining layer as a dielectric layer
7: A combination of a composite of ceramic and aluminum as conductive metal base material and a thermal spray ceramic layer as a dielectric layer
8: A combination of a composite of ceramic and aluminum as conductive metal base material and a glass lining layer as a dielectric layer

In view of the difference in the linear thermal expansion coefficient, the combinations of 1, 2, and 5 through 8 above are preferred, and the combination of 1 described above is more preferred.

In the present invention, titanium or titanium alloy is especially preferred as a metal base material with respect to the above properties. The electrode in which the above described dielectric is coated on the titanium or titanium alloy as a metal base material can resist the long term use under severe conditions without causing cracking, peeling or exfoliation.

The metal base material used in the present invention is a titanium alloy or a titanium metal each containing not less than 70% by weight of titanium. The titanium content of the titanium alloy or titanium metal in the present invention may be at least 70% by weight, but is preferably at least 80% by weight. As the titanium alloy or titanium metal in the present invention, those generally used such as pure titanium for industrial use, corrosion resistant titanium, and high strength titanium. Examples of the titanium for industrial use include TIA, TIB, TIC and TID, each of which contains a minute amount of an iron atom, a carbon, atom, a nitrogen atom, an oxygen atom or a hydrogen atom and at least 99% by weight of titanium. The corrosion titanium is preferably T15PB, which contains a minute amount of the atom described above or lead, and at least 98% by weight of titanium. The titanium alloy is preferably T64, T325, T525 or TA3, each of which contains a minute amount of the atom described above except for lead, aluminum, vanadium or tin, and at least 85% by weight of titanium. Coefficient of thermal expansion of the titanium alloy or titanium metal described above is almost a half of that of stainless steel, for example, AISI316. The titanium alloy or titanium metal, which is employed as a metal base material, is in good combination with the after-mentioned dielectric subjected to being coated on the metal base material, whereby high heat resistance and durability can be provided.

The dielectric in the present invention is preferably an inorganic compound having a dielectric constant of from 6 to 45 as its characteristics. Examples of such an electrode include ceramic such as alumina or silicon nitride, and a glass lining material such as silicate glass or borate glass. Of these, a dielectric layer is coated on the electrode preferably by thermal spraying or glass-lining of ceramic, and more preferably by thermal spraying of alumina.

As one embodiment of electrodes capable of resisting a high electric power as described above, the electrode has a dielectric layer with a void ratio of at most 10% by volume, preferably at most 8% by volume, and most preferably from more than zero to 5% by volume. The void ratio of the dielectric layer can be measured employing a BET adsorption method or a mercury porosimeter. In the examples described later, the void ratio of a dielectric layer coated on a conductive metal base material was measured employing a mercury porosimeter manufactured by Shimadzu Corporation. The dielectric layer having a low void ratio exhibits high durability. A dielectric layer having voids whose volume is low is, for example, a thermally sprayed ceramic layer with high density and high adhesion prepared according to an atmospheric plasma method as described later. In order to further reduce the void ratio, a sealing treatment is preferably conducted.

The atmospheric plasma spraying method is to be a technique in which fine particles or wires of ceramic etc. are introduced into a source of plasma heat to form a melted or semi-melted particles, and the resulting particles are sprayed to a metal base material on which a layer is to be formed. The source of plasma heat herein referred to is a high temperature plasma gas obtained by heating gas molecules to high temperature to dissociate into atoms and applying further energy thereto to release electrons. The spraying speed of this plasma gas is high, and therefore the sprayed gas colloids the metal base material with a spray speed higher than that of a conventional arc spraying or a flame spraying, providing a layer with high adhesion and higher density. A spraying method disclosed in JP-A No. 2000-301655 can be referred to in which a heat shielding layer is formed on material heated to high temperature. The method described above can form a dielectric layer (thermally sprayed ceramic layer) having the void ratio as described above.

Another preferred embodiment of the dielectric-coated electrodes of the present invention capable of resisting high power is a dielectric-coated electrode in which the dielectric layer has a thickness of 0.5 - 2 mm. The variation of the dielectric layer thickness is preferably at most 5%, more preferably at most 3%, and still more preferably at most 1%.

In order to further reduce the void ratio of the dielectric layer, it is preferred that a thermally sprayed layer such as the thermally sprayed ceramic layer is subjected to sealing treatment employing an inorganic compound. The inorganic compound is preferably a metal oxide, and more preferably one containing a silicon oxide ($SiO_x$) as a principal component.

The inorganic compound for sealing is preferably one being hardened through sol-gel reaction. When an inorganic compound for sealing is a compound containing a metal oxide as a principal component, a metal alkoxide is coated on the ceramic spray layer as a sealing solution, and hardened through sol gel reaction. When the inorganic compound for sealing is a compound containing silica as a principal component, an alkoxysilane is preferably used as a sealing solution.

In order to accelerate the sol gel reaction, energy treatment is preferably carried out. Examples of the energy treatment include heat hardening (hardening at not more than 200 °C) or UV exposure. A sealing method, in which the coating and hardening of diluted sealing solution are sequentially repeated several times, provides an electrode exhibiting an improved inorganic property, together with high density with no deterioration.

After coating a metal alkoxide and the like employed for the dielectric-coated electrode of the present invention on a thermally sprayed ceramic layer as a sealing solution, a sealing treatment by hardening via sol gel reaction is conducted. In this case, the metal oxide content after hardening is preferably at least 60 mol%. When an alkoxysilane is used as a metal alkoxide of a sealing solution, the content of SiOx (x: at most 2) after hardening is preferably at least 60 mol%. The content of SiOx after hardening is measured, analyzing the section of the dielectric layer with an XPS (X-ray photoelectron spectroscopy).

In the electrode employed in the layer formation method of the present invention, the surface of the electrode on the side contacting a substrate preferably has a maximum surface roughness Rmax (defined according to JIS B 0601) of at most 10 $\mu$m, in obtaining the effects disclosed in the present invention. The maximum surface roughness Rmax is more preferably at most 8 $\mu$m, and still more preferably at most 7 $\mu$m. The electrode is surface-finished by a polishing treatment so as to obtain such a maximum surface roughness Rmax as described above, which makes it possible to maintain the dielectric layer thickness or a gap between the electrodes constant, to provide stable discharge, and to provide an electrode exhibiting largely increased durability, together with high precision with no strain or cracking due to thermal shrinkage difference or residual stress. It is preferred that at least the surface of the dielectric layer on the side touching the substrate is surface-finished by polishing. Further, the surface of the electrode has a center line average surface roughness Ra (also defined according to JIS B 0601) of preferably at most 0.5 $\mu$m, and more preferably at most 0.1 $\mu$m.

Another preferred embodiment of the dielectric-coated electrodes employed in the present invention capable of resisting high electric power is one having a heat resistant temperature of at least 100 °C, preferably at least 120 °C, and more preferably at least 150 °C. The upper limit of the heat resistant temperature is 500 °C. The heat resistant temperature herein refers to a highest temperature capable of carrying out normal discharge without causing dielectric breakdown at the voltage used in the atmospheric pressure plasma discharge treatment. The above heat resistant temperature can be achieved by employing a layered dielectric having a different foam content produced by glass-lining or thermal spray of ceramic, or by properly selecting the above-described conductive metal base material and the dielectric in which the difference in linear thermal expansion coefficient between the conductive base material and the dielectric falls within the range as described above.

The atmospheric pressure plasma discharge treatment apparatus will now be described referring to drawings.

Fig. 1 is a schematic view showing an example of the structure of the plate electrode type atmospheric pressure plasma discharge treatment apparatus of the preset invention. In process 1 (the region surrounded by the alternate long and short dash line, and this notation is also applied in the following paragraphs), facing electrodes (a discharge space) are formed by a movable platform electrode 8 (a first electrode) as well as a square-shaped electrode 7 (a second electrode) between which a high frequency electric field is applied. Subsequently, gas 1 incorporating discharge gas 11 and film forming gas 12 is fed through gas feeding pipe 15, and is blown into a discharge space through slit 5 formed by the square-shaped electrode 7. Then, gas 1 is excited by plasma discharge, and the surface of substrate placed on movable platform electrode 8 is exposed to excited gas 1 (37 in the figure), whereby a film is formed on the substrate surface.

Subsequently, substrate 4 is gradually conveyed to process 2 (in Fig. 1, the region surrounded by the alternate long and two-short dash line, and this notation is also applied in the following paragraphs), along with movable platform electrode 8. In Fig. 1, the first electrode in process 1 and the third electrode in process 2 are integrated as a common electrode, while the first power source in process 1 and the third power source in process 2 are integrated as a common power source.

In process 2, facing electrodes (forming a discharge space) are formed employing a movable platform electrode 8 (being a third electrode) as well as a square-shaped electrode 3 (being a fourth electrode), and a high frequency electric field is applied to the space between the above facing electrodes. Subsequently, gas 2 incorporating discharge gas 13 and oxidizing gas 14 is fed through gas feeding pipe 16, and is blown into the discharge space through slit 6 formed by square-shaped electrode 3. Then, gas 2 (38 in the figure) is excited by plasma discharge, and the surface of substrate 4 placed on movable platform electrode 8 is exposed to excited gas 2, whereby the film is subjected to an oxidation process. Movable platform electrode 8 incorporates a conveying means (not shown) capable of conveying supporting stand 9 at a constant rate, and capable of stopping the same.

Further, in order to control the temperature of gas 2, it is preferable that temperature controlling means 17 is provided on the way of feeding pipe 16.

Via reciprocating movement between film formation in process 1 and the oxidizing process of process 2 employing a movable platform, it is possible to form a film having a desired film thickness.

First electrode 8 (movable platform electrode) is connected to first power source 31, while second electrode 7 is connected to second power source 33. Further, each of first filter 32 and second filter 34 is connected to the line between its electrode and power source. Filters are employed which are to provide each of functions such that first filter 32 retards the passage of electric current at a specific frequency from power source 31, and enhances the passage of electric current at a frequency from second power source 33, while second filter 34 retards the passage of electric current at a specific frequency from second power source 33 and enhances the passage of electric current at a specific frequency from first power source 31.

In process 1 of the atmospheric pressure plasma discharge treatment apparatus in Fig. 1, a space is formed between first electrode 8 and second electrode 7 facing each other, and applied to the space are: a first high frequency electric field having a frequency of $\omega1$, an electric field strength of V1, and an electric current of 11, which is supplied from first power source 31 through first electrode 8; and a second high frequency electric field having a frequency of $\omega2$, an electric field strength of V2 and an electric current of I2, which is supplied from second power source 33 through second electrode 7. First power source 31 is capable of supplying a high frequency electric field strength which is higher than that of second power source 33 (V1 > V2) while capable of supplying a frequency of $\omega1$ of first power source 8 which is lower than second frequency $\omega2$ of second power source 33.

In process 2, in the same manner, a space is formed between third electrode 8 which is common as the first electrode and second electrode 7 facing each other, and applied to the space are: a first high frequency electric field having a frequency of $\omega1$, an electric field strength of V1, and an electric current of I1, which is supplied from first power source 31 through first electrode 8; and a fourth high frequency electric field having a frequency of $\omega4$, an electric field strength of V4 and an electric current of I4, which is supplied from fourth power source 35 through fourth electrode 3.

First power source 31 is capable of supplying a high frequency electric field strength which is higher than that of fourth power source 35 (V1 > V4) while capable of supplying a frequency of $\omega1$ of first power source 8 which is lower than fourth frequency $\omega4$ of fourth power source 35.

Further, in Fig. 1, shown are measurement instruments employed to determine the aforesaid high frequency electric field (applied electric field strength) as well as the strength of a discharge initiation electric field. Numerals 25 and 26 are high frequency voltage probes, while numerals 27 and 28 are oscilloscopes.

As noted above, by applying two high frequency voltages, which differ in frequency, to square-shaped electrode 7 and movable platform electrode 8 which are facing each other, it is possible to achieve preferable plasma discharge even using less expensive gasses, such as nitrogen. Thereafter, by quickly performing the processing under an oxidizing atmosphere, it is possible to form films which exhibit excellent performance. Incidentally, the present apparatus is suitable for forming a film, employing a plate substrate such as glass, and is particularly suitable for forming a transparent conducive film which exhibits high conductivity and allows easy etching.

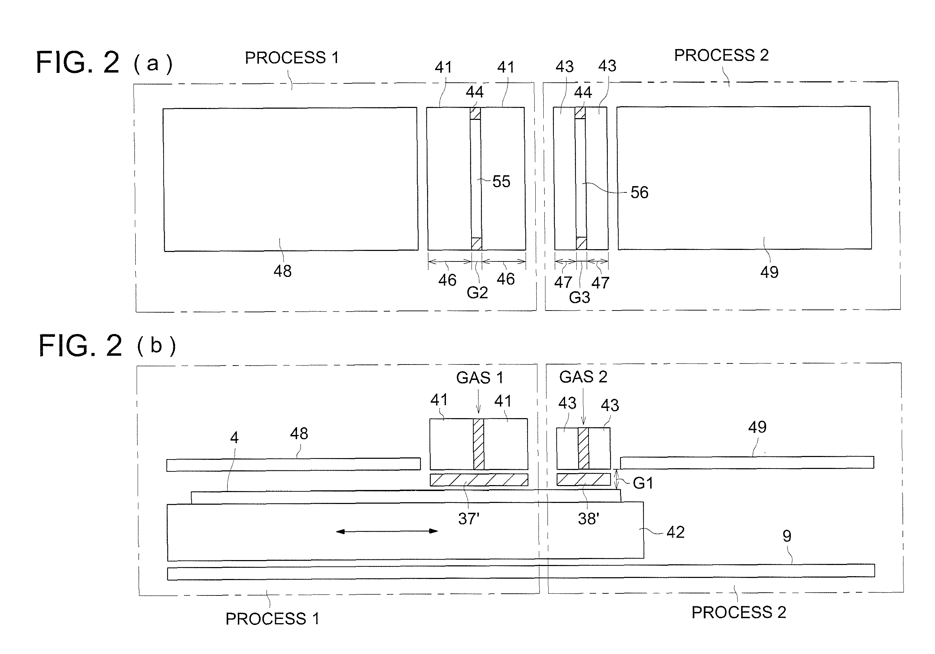

In the present invention, during formation of transparent conductive films, it is more preferable to use a film forming apparatus equipped with shielding blades as shown in Fig. 2. Fig. 2(a) is a plan view of the film forming apparatus, while Fig. 2(b) is a front view of the same. In process 1, facing electrodes are formed employing square-shaped electrode 41 (being a second electrode), in which gas passage slit 55 is formed at the center employing two electrode plates and two space materials 44 as well as movable platform electrode 42 (being a first electrode). Gas 1 fed from the feeding pipe is blown into the discharge space from the outlet of slit 55 and is excited employing plasma in the discharge space formed in the gap between the bottom surface of square-shaped electrode 41 (second electrode) and movable platform electrode 42 (first electrode). Substrate 4 on movable platform electrode 42 is exposed to excited gas 1 (37' in the figure), whereby a film is formed. Movable platform electrode 42 while carrying substrate 4 is gradually conveyed and the film formed on substrate 4 is conveyed to process 2. Gas 2 fed from an oxidizing gas feeding pipe is excited in a discharge space in the same manner as above and the film formed in process 1 is exposed to gas 2 (38'in the figure). In the above apparatus, shielding blades 48 and 49 are provided on both sides of square-shaped electrodes 41 and 43. During preparation of a transparent conductive film, the oxidizing environment of process 2 only requires an extremely small amount of oxygen. Atmospheric air incorporates an excessively large amount of oxygen. Consequently, the above apparatus is suitable to feed oxygen at a controlled concentration to the surface of substrate while retarding the effects of the ambient atmosphere.

It is preferable that the deposited film thickness per operation in process 1 is preferably at most 10 nm, and process 1 and process 2 are repeated several times. The thickness of the resulting film is preferably at least 50 nm and at most 1 $\mu$m.

When the film formed on a substrate is applied to the electrode of various display elements as a transparent conductive film, a patterning process is essential, which draws circuits on a substrate, and further, in terms of process adaptability, important concerns are whether the above patterning is easily performed or not. In many cases, the pattering is performed employing photolithography. Portions, which do not require conduction, are removed by dissolution employing etching. Therefore, the essential requirements include a high dissolution rate and the formation of no residues. The transparent conductive film prepared employing the film production method of the present invention results in highly preferable etching properties.

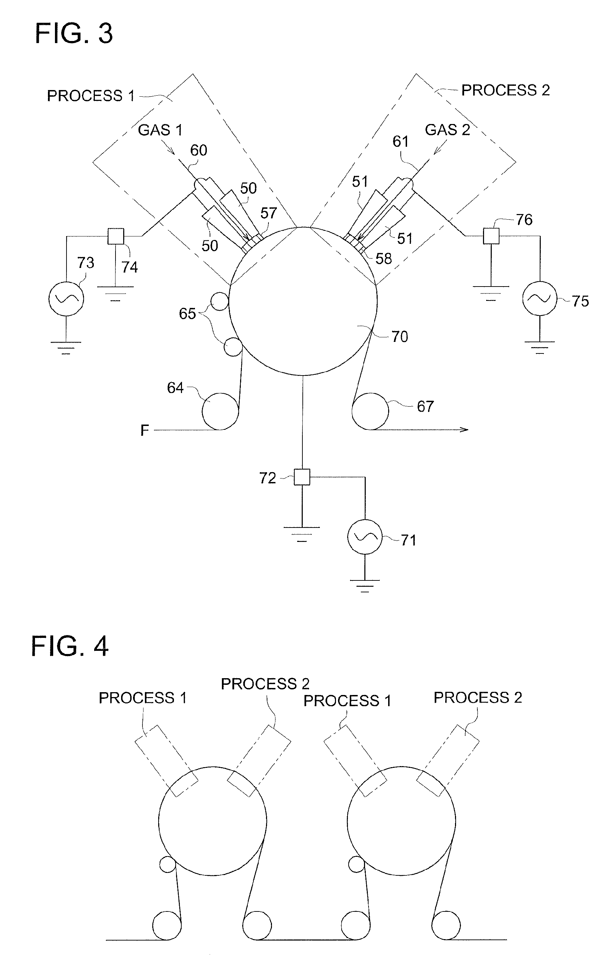

Fig. 3 is a schematic view showing an example of a roller rotating electrode type atmospheric pressure plasma discharge treatment apparatus useful for the present invention.

The atmospheric pressure plasma discharge treatment apparatus shown in Fig. 3 is structured in such a manner that a plasma generating process 1 section which forms a film, and process 2 section, in which oxidizing gases are subjected to plasma excitation, are arranged in series in the rotation direction of roller rotating electrode 70 (first electrode), and further structured in such a manner that the first electrode of process 1 and the third electrode of process 2 are employed as a common roller electrode.

Further, the structure is as follows. Gas 1 is fed from gas feeding pipe 60 to the space (being the discharge space) between facing electrodes composed of roller rotating electrode 70 (first electrode) and square-shaped electrode 50 (second electrode), and the above gas 1 is excited by plasma discharge to form a film on substrate F. In addition, oxidizing gas 2 is fed from gas feeding pipe 61 to the space (discharge space) between the roller rotating electrode 70 (the third electrode and the first electrode are used in common) and square-shaped electrodes 51 (being the fourth electrode), and above gas 2 is excited by plasma discharge so that the surface of the film formed in process 1 is subjected to an oxidation processing.

The first high frequency electric field of a frequency of $\omega 1$, an electric field strength of V1, and a current of I1 from first power source 71 is applied by roller rotating electrode 70 (first electrode) of process 1, while the second high frequency electric field of a frequency of $\omega 2$, an electric field strength of V2, and a current of 12 from second power source 73 is applied by square-shaped electrode 50 (second electrode).

The apparatus is designed as follows. First filter 72 is arranged between roller rotating electrode 70 (first electrode) and first power source 71. First filter 72 allows the electric current to be easily transmitted from first power source 71 to first electrode 70, and the electric current from second power source 73 is grounded, whereby the electric current is prevented to be transmitted from second power source 73 to first power source 71. Further, second filter 74 is arranged between square-shaped electrode 50 (second electrode) and second power source 73. Second filter 74 allows the electric current to be easily transmitted from second power source 73 to second electrode 50, and the electric current from first electrode 71 is grounded, whereby the electric current is prevented to be transmitted from first power source 71 to second power source 73.

Further, process 2 is arranged as follows. A discharge space (between facing electrodes) is formed between roller rotating electrode 70 (the third electrode is common to the first electrode) by which the third high frequency electric field of a frequency of $\omega 3$, an electric field strength of V3, and an electric current of I3 from the thirds power source (being common to the first electrode) is applied, and square-shaped electrode 51 (being the fourth electrode) by which the high frequency electric field of a frequency of ω4, an electric field strength of V4 and an electric current of 14 from fourth power source 75 is applied.

Substrate F, which is fed from a master roll, not shown, while being unwound, or conveyed from the prior process, passes over guide roller 64 and nip roller 65, where nip roller 65 blocks air accompanied with the substrate. Thereafter, while brought into contact with roller rotating electrode 70, it is conveyed to the gap of square-shaped electrode 50 while being wound, and plasma is generated in the space (being the discharge space) between roller rotating electrode 70 (being the first electrode) and square-shaped electrode 50 (being the second electrode). While brought into contact with roller rotating electrode 70, substrate F is wound and gas 1 is excited by plasma, whereby a film is formed on substrate F employing excited gas 1 (57 in Fig. 3). Subsequently, resulting substrate F is conveyed to process 2, and gas 2 incorporating oxidizing gases is excited and an oxidation process is performed in such a manner that the surface on the film is exposed to excited gas 2 (58 in Fig. 3). Thereafter, resulting substrate F is discharged via guide roller 67.

In order to heat or cool roller rotating electrode 70 (first electrode), as well as square-shaped electrodes 50 (second electrode) and 51 (fourth electrode) during formation of films, it is preferable that the medium of which the temperature is adjusted employing an electrode temperature controlling device (not shown) is fed to both electrodes by a liquid feeding pump, and the temperature is adjusted from the interior of the electrodes.

Evacuated substrate F is wound or conveyed to the next process. Wound substrate F may be repeatedly subjected to the same process as described above.

Further, Fig. 4 shows an atmospheric pressure plasma discharge treatment apparatus in which two roller rotating electrode type atmospheric pressure plasma discharge treatment apparatuses as shown in Fig. 3 are connected in series. By employing the above apparatus, substrate F is capable of being subjected to two-stage processing, and also multi-stage processing upon increasing the number of stages. Alternatively, a multilayered film may be formed while changing processing conditions in each of the processing apparatuses.

The above roller rotating electrode type plasma processing apparatus is suitable to form a film employing a film substrate and is capable of forming various films described above. Particularly, it is suitable for the formation of transparent conductive films, as well as antireflection films, anti-glare films and insulation films, employing organic metal compounds capable of having comparatively a thicker film thickness.

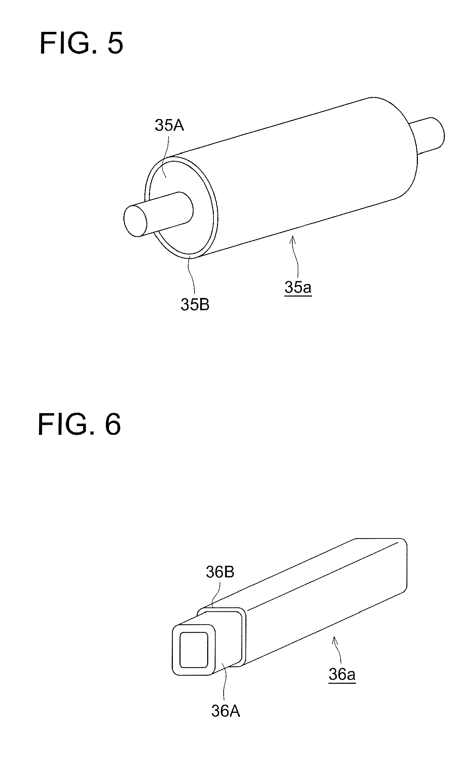

Fig. 5 is a perspective view showing an example of the structure of a conductive metallic base material of the roller rotating electrode as shown in Fig. 3 and covered thereon, a dielectic.

In Fig. 5, roller electrode 35a is composed of conductive metallic base material 35A and dielectric 35B covered thereon. In order to control the temperature of the electrode surface during plasma discharge processing, the structure is such that it is possible to circulate temperature-controlling media (such as water or silicone oil).

Fig. 6 is a perspective view showing one example of the structure of a conductive metallic base material of the movable platform electrode and the square-shaped electrode as shown in Figs 1 - 3, and covered thereon, a dielectric.

In Fig. 6, square-shaped electrode 36 is composed of conductive metallic base material 36A and covered thereon, dielectric 36B in the same manner as in Fig. 5, and the above electrode is structured to form a square metallic pipe serving as a jacket, making it possible to adjust temperature during discharge.

In Figs. 5 and 6, roller electrode 35a and square-shaped electrode 36a are prepared in the following manner. Ceramics as dielectrics 35B and 36B are subjected to flame coating onto conductive metallic base materials 35A and 36B, respectively, and thereafter, a sealing treatment is performed employing inorganic sealing materials. The coverage thickness of the ceramic dielectrics may be approximately 1 mm on one side. Preferably employed as ceramic materials used for flame coating are alumina and silicon nitride. Of these, particularly and preferably employed is alumina. Further, the above dielectric film may be composed of lining-processed dielectrics with inorganic materials arranged via lining.

Also provided can be atmospheric pressure plasma discharge treatment apparatuses described in Japanese Patent O.P.I. Publication Nos. 2004-68143 and 2003-49272, and WO02/48428 in addition to the above-described.

## EXAMPLE

Next, the present invention will now be described in detail referring to examples, but the present invention is not limited thereto.

«Preparation of transparent conductive film»

[Preparation of transparent conductive film 1]

A low density metal oxide layer and a high density metal oxide layer are laminated on a 100 μm thick polyethylene terephthalate film as a substrate to prepare transparent conductive film 1 at the following discharge condition employing an atmospheric pressure plasma discharge treatment apparatus described below.

(Atmospheric pressure plasma discharge treatment apparatus)

The atmospheric pressure plasma discharge treatment apparatus as shown in Fig. 3 was employed. A titanium alloy T64 jacket roll metallic base material having a cooling unit by cooling water was covered by a 1 mm thick thermally sprayed alumina layer exhibiting high density and adhesiveness, employing an atmospheric pressure plasma method, to prepare first electrode 70 (roller electrode). In order to install two second electrodes 50 and 51 (square-shaped electrode) employed in processes 1 and 2 for formation of a low density metal oxide layer of process 1 and a high density metal oxide layer of process 2, a hollow square-shaped cylinder type titanium alloy T64 was covered at the same condition as described above to prepare the same 1 mm thick dielectric, and an interelectrode gap of 1 mm was set on the roller electrode.

Temperature of the first electrode (roller rotating electrode) and the second electrode (square-shaped cylinder type fixed electrodes) was maintained at 80 °C during plasma discharge to form films while rotating the roller rotating electrode with a drive.

[Process 1: layer 1 (low density metal oxide M1 layer)]

Plasma discharge was conducted under the following condition to form a low density metal oxide M1 layer.

<Gas condition>

Discharge gas: Argon gas     20 L/min

Reactive gas:

1) Indium acetylacetonate
(mixed at 150 °C, and vaporized with a
vaporizer manufactured by Lintec Corporation) 10 L/min
2) dibutyl tinacetonate

(mixed at 100 °C, and vaporized with a
vaporizer manufactured by Lintec Corporation)     0.5 L/min
Reducing gas: hydrogen gas                        0.5 L/min

<Power source condition: Only the power

source on the second electrode side was used)

(On the second electrode side)

Power source type: High frequency power source manufactured by Pearl Kogyo Co., Ltd.
Frequency: 13.56 MHz
Output power density: 7 W/cm$^2$
Voltage (V2): 750 V
Current (12): 150 mA
Interelectrode gap: 1mm

[Process 2: layer 2 (high density metal oxide M2 layer)]

Plasma discharge was applied to the low density metal oxide M1 layer surface under the following condition to reform the surface of the M1 layer prepared in process 1, and to form a M2 layer having a reformed layer portion formed in the M1 layer surface portion.

<Gas condition>

| | |
|---|---|
| Discharge gas: Argon gas | 20 L/min |
| Oxidizing gas: Oxygen gas | 0.005 L/min |

<Power source condition: Only the power

source on the fourth electrode side was used)

(On the second electrode side)

Power source type: High frequency power source manufactured by Pearl Kogyo Co., Ltd.
Frequency: 13.56 MHz
Output power density: 7 W/cm$^2$
Voltage (V2): 750 V
Current (12): 150 mA
Interelectrode gap: 1 mm

Each of the transparent conductive films prepared above was sampled to measure densities M1 and M2, and thicknesses D1 and D2 via X-ray reflectrometry according to the foregoing method, employing a measuring apparatus MAC Science MXP21. The following results were obtained. D1 = 1.7 nm, D2 = 2.3 nm, M1 = 6.408 g/cm$^3$, M2 = 6.729 g/cm$^3$, and M2/M1 = 1.050. Next, film forming operations for M1 and M2 in the above-described processes 1 and 2 were repeated via the reciprocal treatment, and were further repeated 24 times to prepare 100 nm thick transparent conductive film 1 composed of 50 layers.

[Preparation of transparent conductive films 2 - 8]

Each of transparent conductive films 2 - 8 having a thickness of 100 nm was prepared similarly to preparation of the above-described transparent conductive film 1, except that a density ratio of M2 (density of a high density metal oxide layer) to M1 (density of a low density metal oxide layer) was replaced by M2/M1 described in Table 1 while appropriately adjusting each metal oxide layer thickness, and gas and power source conditions in processes 1 and 2.

[Preparation of transparent conductive film 9]

Transparent conductive films 9 was prepared similarly to preparation of the above-described transparent conductive film 1, except that only process 1 capable of depositing a 20 nm thick layer per one process was repeated 5 times to form only a low density metal oxide layer having a thickness of 100 nm.

«Density measurement of transparent conductive film»

As to each of transparent conductive films described above, density M1 and density M2 of each layer were measured by X-ray reflectrometry employing MXP21 manufactured by MAC science Ltd to determine M2/M1 according to the foregoing process.

«Characteristic evaluation of transparent conductive film»

[Evaluation of adhesion]

A cross-cut adhesion test based on JIS K 5400 was conducted. Vertical and horizontal incisions were made in the surface of the resulting transparent conductive film 11 cuts-by-11 cuts at 1 mm intervals at a right angle to the surface, employing a single-edged razor blade to prepare 100 1 mm x 1mm grids. A commercially available cellophane tape was attached on the surface, and one end of the tape was vertically peeled. Subsequently, a ratio of the peeled film area to the attached tape area was measured and determined utilizing the above-described incisions to evaluate adhesion according to the following criteria.
A: No film peeling is observed.
B: Film peeling is clearly observed.

[Evaluation of crack resistance]

Each of the resulting transparent conductive films is twisted around a metal bar having a diameter of 300 mm so as to set the transparent conductive film surface on the outer side, and the resulting transparent conductive film was subsequently released after 5 minutes to evaluate a crack resistance property according to the following criteria, after repeating this step 10 times.

A: No occurrence of cracks is observed, and the film exhibits excellent transparency.

B: Occurrence of cracks is slightly observed, and the film becomes slightly milky-white.

C: Occurrence of cracks is largely observed, and the film becomes strongly milky-white.

[Measurement of critical curvature radius]

Each of the transparent conductive films described above was cut into 10 cm vertical and horizontal length pieces. After moistening this transparent conductive film piece at 25 °C and 60%RH for 24 hours, surface resistance was measured employing Loresta GP and MCP-T600 manufactured by Mitsubishi chemical Corporation. This surface resistance was designated as $R_0$. Next, this transparent conductive film piece was twisted around a stainless round bar having radius 10 mm so as to produce no gap. After standing in this situation for 3 minutes, the film was removed to measure the surface resistance again. This measured value was designated as R. The round bar radius was reduced 1 mm-by-1 mm from 10 mm to 1 mm, and the same measurement was repeated. The round bar radius with a value of $R/R_0$ which exceeds 1 was designated as critical curvature radius.

[Measurement of transmittance]

The transmittance at a wavelength of 550 nm was determined employing a spectrophotometer Type U-4000, produced by Hitachi, Ltd. according to JIS-R-1635.

[Measurement of specific resistance]

The specific resistance Determination was determined by a four-point probe method according to JIS-R-1637. In addition, RORESTER GP and MCP-T600 produced by Mitsubishi Chemical Corporation were employed for the measurement.

The measured results are shown in Table 1.

Table 1

| Transparent conductive film No. | Metal oxide layer | | | Evaluation results | | | | | Remarks |
|---|---|---|---|---|---|---|---|---|---|
| | Thickness (nm) | | Density ratio M2/M1 | Adhesion | Crack resistance | Critical curvature radius (mm) | Transmittance (%) | Specific resistance ($10^{-4}$ $\Omega\cdot cm$) | |
| | Layer 1 | Layer 2 | | | | | | | |
| 1 | 2.0 | 2.0 | 1.050 | A | A | 4 | 92 | 3.1 | Inv. |
| 2 | 2.0 | 2.0 | 1.102 | A | A | 3 | 90 | 3.5 | Inv. |
| 3 | 2.0 | 2.0 | 1.202 | A | A | 4 | 89 | 3.3 | Inv. |
| 4 | 2.0 | 2.0 | 1.349 | A | A | 5 | 88 | 3.8 | Inv. |
| 5 | 10.0 | 10.0 | 1.102 | A | A | 4 | 90 | 4.0 | Inv. |
| 6 | 20.0 | 20.0 | 1.100 | A | B | 6 | 90 | 6.0 | Inv. |
| 7 | 2.0 | 2.0 | 1.450 | B | B | 11 | 82 | 22 | Comp. |
| 8 | 3.0 | 3.0 | 1.600 | B | C | 13 | 80 | 112 | Comp. |
| 9 | 20.0 | - | - | A | C | 30 | 90 | 5.0 | Comp. |
| Inv.: Present invention, Comp.: Comparative example | | | | | | | | | |

As is clear from Table 1, it is to be understood that transparent conductive films of the present invention being within the range of M2/M1 specified in the present invention, of which ratio is obtained via alternate lamination of a low density metal oxide layer and a high density metal oxide layer that are made of metal oxide substantially having the same constituent components, exhibit excellent adhesion to a substrate, excellent crack resistance and small critical curvature radius, together with high transparency and conductivity in comparison to those of Comparative examples.

Example 2

Transparent conductive films 8 - 11 were prepared similarly to preparation of transparent conductive films 1 - 4 in Example 1, except that M2/M1 was the same value, and density gradient was produced in layers employing low and high density metal oxide layers via placement of the second electrode used in processes 1 and 2 so as to produce - 2 degree with respect to the first electrode, and each evaluation was also made similarly to a method described in Example 1. As a result, the same level of properties or better of transparent conductive films 1 - 6 described in Example 1 was confirmed.

**POSSIBILITY OF INDUSTRIAL USE**

In the present invention, provided can be a transparent conductive film exhibiting excellent adhesion to a substrate and excellent crack resistance, together with high transparency and conductivity.

**Claims**

1. A transparent conductive film comprising a substrate having thereon:

   a low density metal oxide layer made of metal oxide; and
   a high density metal oxide layer made of metal oxide that are alternately laminated layer by layer,

   wherein the transparent conductive film satisfies a condition specified by the following inequality (1);

   $$1.01 \leq M2/M1 \leq 1.400 \ ...(1),$$

   provided that a density of the low density metal oxide layer and a density of the high density metal oxide layer are represented by M1 and M2, respectively.

2. The transparent conductive film of Claim 1,
   wherein the low density metal oxide layers and the high density metal oxide layers are provided on a transparent substrate.

3. The transparent conductive film of Claim 1,
   wherein the low density metal oxide layers and the high density metal oxide layers are provided on a flexible substrate.

4. The transparent conductive film of Claim 1,
   wherein the metal oxide comprises one element selected from the group consisting of In, Zn, Sn, Ti, Ga and Al.

5. The transparent conductive film of Claim 1,
   wherein the metal oxide comprises one metal oxide selected from the group consisting of $In_2O_3$, $ZnO$, $SnO_2$ and $TiO_2$.

6. The transparent conductive film of Claim 1, wherein each of the low density metal oxide layers and the high density metal oxide layers has a thickness of 0.1 - 20 nm.

7. The transparent conductive film of Claim 1,
   wherein at least one of the low density metal oxide layers and the high density metal oxide layers preferably has a gradient in density distribution in the layer.

8. The transparent conductive film of Claim 1,

wherein the total number of the low density metal oxide layers and the high density metal oxide layers is at least 5 layers.

9. The transparent conductive film of Claim 1, prepared via process 1 comprising the steps of supplying gas 1 containing a metal oxide-forming gas in a first discharge space in which a high frequency electric field is generated for excitation; and forming the low density metal oxide layer made of the metal oxide on a substrate by exposing the substrate to the excited gas 1, and subsequently via process 2 further comprising the steps of supplying gas 2 containing an oxidizing gas in a discharge space in which a high frequency electric field is generated for excitation; and forming the high density metal oxide layer made of the metal oxide on the low density metal oxide layer by exposing the low density metal oxide layer to the excited gas 2.

10. The transparent conductive film of Claim 9,
wherein the gas 1 comprises a reducing gas.

# FIG. 1

PROCESS 1                    PROCESS 2

FIG. 2 (a)

PROCESS 1

41    41    43    43    PROCESS 2

44    44

55    56

48    49

46    46    47    47

G2    G3

FIG. 2 (b)

GAS 1    GAS 2

41    41    43    43    49

4    48

G1

37'    38'    42    9

PROCESS 1    PROCESS 2

EP 1 796 108 A1

24

# FIG. 3

# FIG. 4

# FIG. 5

35A

35B

35a

# FIG. 6

36B

36A

36a

**INTERNATIONAL SEARCH REPORT**

| International application No. |
|---|
| PCT/JP2005/016897 |

A. CLASSIFICATION OF SUBJECT MATTER
*H01B5/14*(2006.01), *H01B13/00*(2006.01), *C23C16/40*(2006.01)

According to International Patent Classification (IPC) or to both national classification and IPC

B. FIELDS SEARCHED

Minimum documentation searched (classification system followed by classification symbols)
*H01B5/14*(2006.01), *H01B13/00*(2006.01), *C23C16/40*(2006.01)

Documentation searched other than minimum documentation to the extent that such documents are included in the fields searched
Jitsuyo Shinan Koho          1922-1996    Jitsuyo Shinan Toroku Koho    1996-2005
Kokai Jitsuyo Shinan Koho    1971-2005    Toroku Jitsuyo Shinan Koho    1994-2005

Electronic data base consulted during the international search (name of data base and, where practicable, search terms used)
WPI/L

C. DOCUMENTS CONSIDERED TO BE RELEVANT

| Category* | Citation of document, with indication, where appropriate, of the relevant passages | Relevant to claim No. |
|---|---|---|
| A | JP 2003-132738 A  (Nippon Sheet Glass Co., Ltd.), 09 May, 2003 (09.05.03), Claims; Par. Nos. [0026] to [0057] (Family: none) | 1-10 |
| A | JP 2000-285737 A  (Hoya Corp.), 13 October, 2000 (13.10.00), Claims; Par. Nos. [0032] to [0034] (Family: none) | 1-10 |
| A | JP 7-262829 A  (Hitachi, Ltd.), 13 October, 1995 (13.10.95), Claims; Par. Nos. [0034] to [0039] (Family: none) | 1-10 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 11 November, 2005 (11.11.05) | 22 November, 2005 (22.11.05) |

| Name and mailing address of the ISA/ Japanese Patent Office | Authorized officer |
|---|---|
| Facsimile No. | Telephone No. |

Form PCT/ISA/210 (second sheet) (April 2005)

EP 1 796 108 A1

## INTERNATIONAL SEARCH REPORT

International application No.

PCT/JP2005/016897

C (Continuation). DOCUMENTS CONSIDERED TO BE RELEVANT

| Category* | Citation of document, with indication, where appropriate, of the relevant passages | Relevant to claim No. |
|---|---|---|
| A | JP 6-103817 A (Hitachi, Ltd.), 15 April, 1994 (15.04.94), Claims; Par. Nos. [0010] to [0022] (Family: none) | 1-10 |

Form PCT/ISA/210 (continuation of second sheet) (April 2005)

**REFERENCES CITED IN THE DESCRIPTION**

**Patent documents cited in the description**

- JP 6060723 A
- JP 8174746 A
- JP 3338093 B
- JP 2004042412 A
- JP 2003342735 A
- JP 2000301655 A
- JP 2004068143 A
- JP 2003049272 A
- WO 0248428 A

**Non-patent literature cited in the description**

- **D. A. SHIRLEY.** *Phys. Rev.,* 1972, vol. B5, 4709
- Hand Book of X Ray Diffraction. Kokusai Bunken In-satsu Corp, 2000, 151
- *Kagaku Kougyo,* January 1999